# EUROPÄISCHE PATENTSCHRIFT

(11) **EP 2 646 597 B1**
(45) Veröffentlichungstag und Bekanntmachung des Hinweises auf die Patenterteilung: **14.09.2016**
(21) Anmeldenummer: 11791254.3
(22) Anmeldetag: 24.11.2011
(51) Int. Cl.: C23C 16/26, F16J 9/26, C23C 14/06, C23C 28/00

(54) **GLEITELEMENT, INSBESONDERE KOLBENRING, MIT EINER BESCHICHTUNG**
SLIDING ELEMENT, IN PARTICULAR A PISTON RING, HAVING A COATING
ÉLÉMENT DE GLISSEMENT, EN PARTICULIER SEGMENT DE PISTON, POURVU D'UN REVÊTEMENT

(30) Priorität: 29.11.2010 DE 102010062114
(43) Veröffentlichungstag der Anmeldung: 09.10.2013
(73) Patentinhaber: Federal-Mogul Burscheid GmbH, 51399 Burscheid (DE)
(72) Erfinder: KENNEDY, Marcus, 40477 Düsseldorf (DE); ZINNABOLD, Michael, 51399 Burscheid (DE)
(74) Vertreter: Hoffmann Eitle
(86) Internationale Anmeldenummer: PCT/EP2011/070921
(87) Internationale Veröffentlichungsnummer: WO 2012/072483

(56) Entgegenhaltungen:
- WO-A1-2010/021285
- DE-A1-102008 011 921
- DE-B3-102008 016 864
- JP-A- 2002 032 907
- US-B1- 6 354 008
- MIKI H ET AL: "Tribological properties of multilayer DLC/W-DLC films on Si", THIN SOLID FILMS, ELSEVIER-SEQUOIA S.A. LAUSANNE, CH, vol. 516, no. 16, 30 June 2008 (2008-06-30), pages 5414-5418, XP023904235, ISSN: 0040-6090, DOI: 10.1016/J.TSF.2007.07.113 [retrieved on 2008-06-30]

## Beschreibung

### Technisches Gebiet

Die Erfindung betrifft ein Gleitelement, insbesondere einen Kolbenring mit einer Beschichtung auf zumindest einer Lauffläche.

Gleitelemente, wie z.B. Kolbenringe, Kolben oder Zylinderlaufbuchsen in Verbrennungsmotoren müssen über eine lange Lebensdauer sowohl bei möglichst geringer Reibung als auch mit geringem Verschleiß arbeiten. Zwar kann die Reibung, die bei Verbrennungsmotoren unmittelbar mit dem Kraftstoffverbrauch einhergeht, durch Beschichtungen aus DLC (diamond-like carbon) gering gehalten werden. Ferner können grundsätzlich Schichtdicken bis 40 µm erreicht werden. Jedoch ergibt sich bei Schichtdicken von mehr als 5 µm das Problem, dass sich die Schichteigenschaften, beispielsweise im Hinblick auf den Aufbau und die Zusammensetzung der Schicht, verändern, so dass die geforderte Lebensdauer nicht erreicht wird. Dies gilt in gleicher Weise für Schichtdicken von weniger als 5 µm.

### Stand der Technik

Bekannt sind in diesem Zusammenhang ferner PVD-Beschichtungen auf Hartstoffbasis, die zumeist Chromnitrid aufweisen. Derartige Schichten haben zwar die erforderliche Verschleißbeständigkeit, nicht jedoch die notwendigen niedrigen Reibkoeffizienten.

Aus der DE 10 2005 063 123 B3 ist ein Gleitelement mit einer DLC-Beschichtung mit gutem Einlaufverhalten bekannt. Insgesamt ist jedoch die Dauerhaftigkeit eines niedrigen Reibungskoeffizienten weiter verbesserungsfähig.

Die DE 10 2008 016 864 betrifft ein Gleitelement mit einer Beschichtung, die von innen nach außen eine Haftschicht, eine metallhaltige DLC-Schicht und eine metallfreie DLC-Schicht aufweist.

Aus der DE 197 35 962 A1 geht eine Führungsbuchse und ein Verfahren zur Ausbildung eines harten Kohlenstofffilms auf der Innenfläche der Führungsbuchse hervor, bei dem auf der Innenfläche ein harter Kohlenstofffilm aus hydriertem, amorphen Kohlenstoff durch ein Plasma-CVD-Verfahren ausgebildet wird.

Die EP 2 316 983 A1 betrifft ein Gleitelement, das auf zumindest einer Fläche von innen nach außen eine Haftschicht, eine metallhaltige DLC-Schicht und eine metallfreie DLC-Schicht aufweist, die mit Stickstoff dotiert sein kann.

Die US 6,354,008 B1 betrifft ein Gleitelement, das gemäß einem Beispiel eine DLC-Schicht und darauf eine CN-Schicht mit graduiertem Stickstoffgehalt aufweist.

Schließlich zeigt die WO 2006/125683 A1 einen Kolbenring, der von innen nach außen eine Schicht mit einem Element der Gruppen IVB, VB oder VIB, eine Zwischenschicht mit einer diamantartigen Nanokomposit-Zusammensetzung und eine DLC-Schicht aufweist.

### Darstellung der Erfindung

Vor diesem Hintergrund liegt der Erfindung die Aufgabe zugrunde, ein Gleitelement zur Verfügung zu stellen, das im Hinblick auf die Kombination aus Reibungskoeffizienten und Verschleißeigenschaften weiter verbessert ist.

Die Lösung dieser Aufgabe erfolgt durch das im Anspruch 1 beschriebene Gleitelement.

Demzufolge weist dieses auf zumindest einer Fläche eine Beschichtung auf, die von innen nach außen eine Haftschicht, eine metall-, insbesondere wolframhaltige DLC-Schicht und eine metallfreie DLC-Schicht aufweist. Die Beschichtung kann insbesondere auf zumindest einer Lauffläche vorgesehen sein. Alternativ oder ergänzend hierzu ist jedoch auch die Beschichtung zumindest einer Flanke möglich. Die Haftschicht ist bevorzugt eine Chrom-Haftschicht. Die metallhaltige DLC-Schicht weist amorphen Kohlenstoff auf und kann mit a-C:H:Me und als die bevorzugte wolframhaltige DLC-Schicht als a-C:H:W bezeichnet werden. Die äußerste oder Topschicht weist ebenfalls amorphen Kohlenstoff auf und kann mit a-C:H angegeben werden. Bei den beschriebenen Werten wurden besonders gute Eigenschaften im Hinblick auf Reibung und Verschleiß festgestellt. Diese tribologischen Eigenschaften können durch eine dickere Topschicht in Richtung einer längeren Lebensdauer beeinflusst werden. Wenn diese jedoch im Vergleich zur mittleren Schicht zu dick wird, verschlechtern sich die Verschleißwerte, da die hohen Schichteigenspannungen die Haftfestigkeit reduzieren und dies zu einer Delamination führen kann.

Für die Dotierung der metallfreien DLC-Schicht konnte insbesondere für die Verwendung von Stickstoff festgestellt werden, dass hierdurch in vorteilhafter Weise die Eigenspannungen der Schicht reduziert werden. Um eine hohe Lebensdauer der Schicht gewährleisten zu können, wird die metallfreie DLC-Schicht insbesondere mit Stickstoff dotiert, insbesondere, sobald die kritische Schichtdicke erreicht ist. Hierdurch werden, wie erwähnt, Eigenspannungen reduziert, so dass hohe Schichtdicken ausgebildet werden können. Erste Versuche auf einem Verschleißprüfstand haben gute Ergebnisse hervorgebracht. Im Hinblick auf Details der Dotierung mit Stickstoff und der dadurch erreichbaren Vorteile wird auf den Artikel "Plasma-deposited a-C(N):H films" von D.F. Franceschini, Brazilian Journal of Physics, vol. 30, No. 3, Sao Paulo 2000 verwiesen Während die Beschichtung auf zumindest einer Lauffläche des Gleitelements, zumindest teilweise, ausgebildet ist, kann sie sich über die gesamte Lauffläche erstrecken und insbesondere auch auf Flächen ganz oder teilweise ausgebildet sein, die an die Laufflächen angrenzen, wie z.B. die Flanken eines Kolbenrings und/oder an dem Übergang von der Lauffläche zu den daran angrenzenden Flächen.

Ferner wird derzeit erwartet, dass ein graduierter Verlauf des Stickstoffanteils über die metallfreie DLC-Schicht ergänzend für einen guten Eigenspannungsverlauf sorgt.

Um die beschriebene Balance zwischen Reibbeiwert und Verschleißeigenschaften besonders gut zu lösen, beträgt eine Gesamtdicke der Beschichtung 5 µm bis 40 µm. Insbesondere werden etwa 10-20 µm bevorzugt.

Bevorzugte Weiterbildungen des erfindungsgemäßen Gleitelements sind in den weiteren Ansprüchen beschrieben.

Als Grundwerkstoff des Gleitelements, insbesondere des Kolbenrings wird derzeit Gusseisen oder Stahl bevorzugt. Für diese Werkstoffe konnten besonders gute Eigenschaften festgestellt werden.

Im Hinblick auf die Härte der Schicht werden Werte von 1400 HV0.02 bis 2900 HV0.02 für die metallfreie (a-C:H-, Top-) DLC-Schicht und/oder 800 bis 1600 HV0.02 für die metallhaltige (a-C:H:Me-) DLC-Schicht bevorzugt, da bei diesen Werten eine gute Erfüllung der Anforderungen hinsichtlich Schichtadhäsion und -cohäsion erreicht wurde.

Sowohl die metallhaltige als auch die metallfreie DLC-Schicht kann Wasserstoff enthalten, was sich bei Versuchen als günstig erwiesen hat.

Ferner wird für die wolframhaltige DLC-Schicht bevorzugt, dass sie nanokristalline Wolframcarbidausscheidungen enthält, was sich auf die Eigenschaften weiter günstig auswirkt.

Für die Dicke der Haftschicht, die insbesondere eine Chromhaftschicht ist, wird ein Wert von maximal 1 µm bevorzugt.

Im Hinblick auf eine effiziente Ausbildung der Beschichtung wird für die Haftschicht derzeit bevorzugt, dass sie metallisch aufgedampft ist.

Eine günstige Herstellung der erfindungsgemäßen Beschichtung wird ferner im Hinblick auf die metallhaltige und/oder metallfreie DLC-Schicht gewährleistet, wenn diese mittels eines PVD- und/oder PA-CVD-Verfahrens ausgebildet sind. Insbesondere können für einzelne oder mehrere Schichten der erfindungsgemäßen Beschichtung die beiden genannten Verfahren kombiniert werden. Für die Dotierung mit Stickstoff wird der Stickstoff während des Verfahrens im Wesentlichen als Gas hinzugefügt, so dass sich neben dem Kohlenstoff, der sich durch die Ionisierung von Acetylen im Plasma ergibt, Stickstoff abscheidet und die Schicht, wie beschrieben, dotiert wird. Eine ausführliche Beschreibung des Prozesses ist u.a. im Artikel "Diamond-like amorphous Carbon" von J. Robertson, Material Science and Engineering R 37 (2002), 129-281 zu finden.

Bevorzugt liegt das Dickenverhältnis zwischen der metallfreien und der metallhaltigen DLC-Schicht zwischen 0,7 und 1,5 und/oder das Verhältnis der Dicken zwischen der metallfreien DLC-Schicht und der Beschichtung insgesamt zwischen 0,4 und 0,6. Besonders gute Verschleißwerte konnten festgestellt werden, wenn die mittlere und die Topschicht eine nahezu identische Dicke aufweisen, so dass hier ein Dickenverhältnis von etwa 1,0, insbesondere 0,9 bis 1,1 bzw. ein Dickenverhältnis der Top- zur Gesamtschicht von etwa 0,5, insbesondere 0,45 bis 0,55 bevorzugt wird. Besonders bevorzugt wird derzeit eine Gesamtschichtdicke von beispielsweise 10-20 µm, wobei die metallhaltige DLC-Schicht eine Dicke von etwa 40-70% Prozent der Gesamtschicke ausmacht, und die metallfreie DLC-Schicht eine Dicke von etwa 4,4 bis etwa 7,6 µm aufweist.

Im Hinblick auf die Reibung konnten für Beschichtungen innerhalb der genannten Bereiche Reibwerte festgestellt werden, welche die in einem Verbrennungsmotor gestellten Anforderungen gut erfüllen und insbesondere weitgehend konstant sind. Im Gegensatz dazu wurden außerhalb dieser Bereiche bereits nach kurzer Zeit hohe Reibwertspitzen und ein inkonstanter Reibverlauf festgestellt.

Als Erklärung für dieses Verhalten, worauf die Erfindung jedoch nicht beschränkt ist, wird derzeit angesehen, dass die metallfreie DLC-Schicht zunächst sehr hohe Eigenspannungen in das Gesamtsystem, also die Beschichtung insgesamt einbringt, die bei einer Schichtdicke der metallhaltigen DLC-Schicht, die ähnlich zu der Dicke der äußersten Schicht ist, derart ausgeglichen werden können, dass die Beschichtung hinsichtlich der Kombination zwischen Festigkeit und Zähigkeit optimal ausgebildet ist. Somit besitzt ein damit beschichtetes Gleitelement, insbesondere ein Kolbenring, einen guten Verschleißwiderstand. Bei Schichtdickenverhältnissen zwischen der metallfreien und der metallhaltigen DLC-Schicht von < 0,7 und/oder von Top- zu Gesamtschicht von < 0,4 besitzt das Gleitelement eine zu geringe Lebensdauer, da die äußerste metallfreie DLC-Schicht zwar einen hohen Verschleißwiderstand jedoch eine zu geringe Schichtdicke aufweist. Im Gegensatz hierzu reicht bei einem Schichtdickenverhältnis zwischen der metallfreien und der metallhaltigen DLC-Schicht von > 1,5 und/oder zwischen Topzu Gesamtschicht von > 0,6 die Dicke der metallhaltigen DLC-Schicht nicht aus, um die Eigenspannungen auszugleichen. Dies führt zu einem frühzeitigen Verschleiß der DLC-Schicht insgesamt trotz der großen Dicke der äußersten Schicht oder zu einem Abplatzen der DLC-Schicht durch zu hohe Belastungen während des Betriebs. Soll die Schichtdicke der metallfreien a-C:H Schichtlage weiter erhöht werden, ist das durch eine Stickstoffdotierung möglich, da dadurch die Eigenspannungen abgebaut und durch die verbesserte Leitfähigkeit der Topschicht der Beschichtungsprozess stabiler verläuft. Der Abbau der Eigenspannungen führt des weiteren zu einem verbesserten Reibverhalten.

Bei ersten Versuchen hat sich ferner ein Stickstoffanteil von mehr als 5 At% und/oder höchstens 40 At% bewährt. Insbesondere werden derzeit 10 At% bis 25 At% bevorzugt.

Bevorzugt ist ein äußerer Bereich der metallfreien DLC-Schicht mit Stickstoff dotiert.

Im Hinblick auf den Dickenanteil, den der dotierte Bereich in der metallfreien DLC-Schicht einnimmt, wird eine Dicke von 10 bis 90 % des nichtdotierten Bereichs bevorzugt. Hierfür konnten bei ersten Versuchen gute Ergebnisse festgestellt werden.

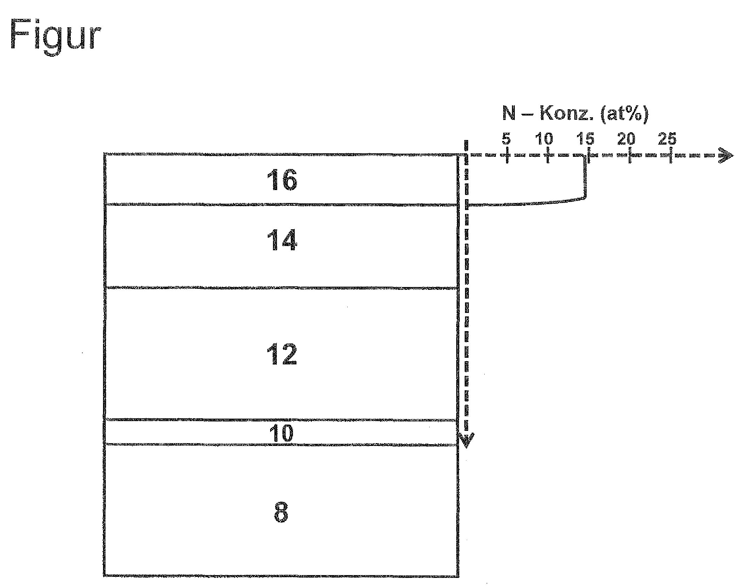

### Kurze Beschreibung der Zeichnung

Nachfolgend werden bevorzugte Ausführungsbeispiele der Erfindung unter Bezugnahme auf die Zeichnung näher erläutert.

Die Figur zeigt schematisch den Aufbau der erfindungsgemäßen Beschichtung

### Ausführliche Beschreibung bevorzugter Ausführungsformen der Erfindung

Wie in der Figur schematisch dargestellt ist, weist die erfindungsgemäße Beschichtung auf einem Substrat 8, von innen nach außen, eine Haftschicht 10, eine metallhaltige DLC-Schicht 12 und eine Topschicht 14, 16 auf, bei der es sich um eine metallfreie DLC-Schicht handelt. Bei dem gezeigten Ausführungsbeispiel ist ein äußerer Bereich 16 mit Stickstoff dotiert, während ein innerer Bereich 14 nicht mit Stickstoff dotiert ist. In dem gezeigten Beispiel liegt die Stickstoffkonzentration in dem dotierten Bereich bei etwa 15 % und ist an dem Übergang von dem dotierten zu dem nichtdotierten Bereich nur geringfügig graduiert. Mit anderen Worten fällt der Stickstoffgehalt über einen vergleichsweise geringen Dickenbereich auf 0 ab. Dieser Verlauf kann jedoch ebenso gut graduiert ausgebildet sein.

### Beispiele

Die Eigenschaften der erfindungsgemäßen Beschichtung wurden wie folgt überprüft. Versuche wurden mit 2 Kolbenringen durchgeführt, wobei die Topschicht der Laufflächenbeschichtung zu einem dotiert und in einer weiteren Ausführungsform nicht dotiert ist.

Für die dotierte Variante wurde ein um ca. 20% geringerer Reibkoeffizient gemessen. Dies ist dadurch zu erklären, dass durch eine Stickstoffdotierung der Anteil an sp2-hybrisierten Kohlenstoffatomen steigt. Sp2-hybrisierte Kohlenstoffatome haben eine grafitähnliche Kristallstruktur, die es ermöglicht, dass bei Scherbeanspruchungen die einzelnen Kristallebenen in eine Raumrichtung abgleiten können und damit die mechanische Energie durch eine Verschiebung der Kristallebenen aufgenommen werden kann. Dies führt zu einer geringeren Reibung als bei Schichtsystemen mit geringeren sp2-Anteil. Es ist zu beachten, dass der sp2-Anteil nicht zu hoch eingestellt werden sollte, da dadurch der Verschleißwiderstand reduziert wird.

## Patentansprüche

1. Gleitelement, wie z.B. Kolbenring, mit einer Beschichtung auf zumindest einer Fläche, die von innen nach außen eine Haftschicht (10), eine metall-, vorzugsweise wolframhaltige DLC-Schicht (12) und eine metallfreie DLC-Schicht (14, 16) aufweist,
**dadurch gekennzeichnet, dass** die metallfreie DLC-Schicht zumindest bereichsweise mit Stickstoff dotiert ist, wobei der Stickstoffgehalt in der metallfreien DLC-Schicht graduiert ist, und die Gesamtdicke der Beschichtung 5 µm bis 40 µm beträgt.

2. Gleitelement nach Anspruch 1,
**dadurch gekennzeichnet, dass**
dieses als Grundwerkstoff Gusseisen oder Stahl aufweist.

3. Gleitelement nach Anspruch 1 oder 2,
**dadurch gekennzeichnet, dass**
die metallfreie DLC-Schicht eine Härte von 1400 HV0.02 bis 2900 HV0.02 und/oder die metallhaltige DLC-Schicht eine Härte von 800 bis 1600 HV0.02 aufweist.

4. Gleitelement nach einem der vorangehenden Ansprüche,
**dadurch gekennzeichnet, dass**
die metallhaltige und/oder die metallfreie DLC-Schicht Wasserstoff enthalten.

5. Gleitelement nach einem der vorangehenden Ansprüche,
**dadurch gekennzeichnet, dass**
die wolframhaltige DLC-Schicht nanokristalline Wolframcarbidausscheidungen enthält.

6. Gleitelement nach einem der vorangehenden Ansprüche,
**dadurch gekennzeichnet, dass**
die Haftschicht, insbesondere eine Chrom-Haftschicht, eine Dicke von maximal 1 µm aufweist.

7. Gleitelement nach einem der vorangehenden Ansprüche,
**dadurch gekennzeichnet, dass**
die Haftschicht metallisch aufgedampft ist.

8. Gleitelement nach einem der vorangehenden Ansprüche,
**dadurch gekennzeichnet, dass**
die metallhaltige und/oder die metallfreie DLC-Schicht mittels eines PVD- und/oder PA-CVD-Verfahrens ausgebildet sind.

9. Gleitelement nach einem der vorangehenden Ansprüche,
**dadurch gekennzeichnet, dass**
die Dicke der metallfreien DLC-Schicht zur Dicke der metallhaltigen DLC-Schicht ein Verhältnis von 0,7 bis 1,5 und/oder zur Gesamtdicke der Beschichtung ein Verhältnis von 0,4 bis 0,6 aufweist.

10. Gleitelement nach einem der vorangehenden Ansprüche,
**dadurch gekennzeichnet, dass**
die metallfreie DLC-Schicht einen Stickstoffanteil von mehr als 5 At% und/oder höchstens 40 At%, bevorzugt zwischen 10 At% und 25 At% aufweist.

11. Gleitelement nach einem der vorangehenden Ansprüche,
**dadurch gekennzeichnet, dass**
ein äußerer Bereich der metallfreien DLC-Schicht dotiert ist.

12. Gleitelement nach einem der vorangehenden Ansprüche,
**dadurch gekennzeichnet, dass**
die Dicke des dotierten Bereichs der metallfreien DLC-Schicht 10 bis 90 % der Dicke des nichtdotierten Bereichs der metallfreien DLC-Schicht beträgt.

## Claims

1. Sliding element, such as for example piston ring, having a coating on at least one surface which has from the inside to the outside an adhesive layer (10), a metal-containing, preferably tungsten-containing DLC layer (12) and a metal-free DLC layer (14, 16), **characterised in that** the metal-free DLC layer is doped with nitrogen at least in some regions, wherein the nitrogen content in the metal-free DLC layer is graduated, and the total thickness of the coating is 5 µm to 40 µm.

2. Sliding element according to claim 1, **characterised in that** the latter has cast iron or steel as base material.

3. Sliding element according to claim 1 or 2, **characterised in that** the metal-free DLC layer has a hardness of 1,400 HV0.02 to 2,900 HV0.02 and/or the metal-containing DLC layer has a hardness of 800 to 1,600 HV0.02.

4. Sliding element according to one of the preceding claims, **characterised in that** the metal-containing and/or the metal-free DLC layer contain hydrogen.

5. Sliding element according to one of the preceding claims, **characterised in that** the tungsten-containing DLC layer contains nanocrystalline tungsten carbide deposits.

6. Sliding element according to one of the preceding claims, **characterised in that** the adhesive layer, in particular a chromium adhesive layer, has a thickness of not more than 1µm.

7. Sliding element according to one of the preceding claims, **characterised in that** the adhesive layer is effected by metal vapour deposition.

8. Sliding element according to one of the preceding claims, **characterised in that** the metal-containing and/or the metal-free DLC layer are formed by means of a PVD process and/or PA-CVD process.

9. Sliding element according to one of the preceding claims, **characterised in that** the thickness of the metal-free DLC layer to the thickness of the metal-containing DLC layer has a ratio of 0.7 to 1.5 and/or to the total thickness of the coating a ratio of 0.4 to 0.6.

10. Sliding element according to one of the preceding claims, **characterised in that** the metal-free DLC layer has a nitrogen content of more than 5 at% and/or not more than 40 at%, preferably between 10 at% and 25 at%.

11. Sliding element according to one of the preceding claims, **characterised in that** an outer region of the metal-free DLC layer is doped.

12. Sliding element according to one of the preceding claims, **characterised in that** the thickness of the doped region of the metal-free DLC layer is 10 to 90 % of the thickness of the non-doped region of the metal-free DLC layer.

## Revendications

1. Elément de glissement, par exemple segment de piston, comprenant un revêtement sur au moins une face, qui présente, de l'intérieur vers l'extérieur, une couche adhésive (10), une couche métallique, de préférence une couche DLC (12) contenant du tungstène et une couche DLC (14, 16) sans métal,
**caractérisé en ce**
**que** la couche DLC sans métal est dopée au moins par endroits avec de l'azote,
la teneur en azote dans la couche DLC sans métal étant graduée
et
l'épaisseur totale du revêtement présentant une valeur allant de 5 µm à 40 µm.

2. Elément de glissement selon la revendication 1,
**caractérisé en ce**
**que** ce dernier présente, en tant que matériau de base, de la fonte ou de l'acier.

3. Elément de glissement selon la revendication 1 ou 2,
**caractérisé en ce**
**que** la couche DLC sans métal présente une dureté allant de 1 400 HV0.02 à 2 900 HV0.02, et/ou en ce que la couche DLC contenant du métal présente une dureté allant de 800 à 1 600 HV0.02.

4. Elément de glissement selon l'une quelconque des
revendications précédentes,
**caractérisé en ce**
**que** la couche DLC contenant du métal et/ou la couche DLC sans métal contiennent de l'hydrogène.

5. Elément de glissement selon l'une quelconque des revendications précédentes,
**caractérisé en ce**
**que** la couche DLC contenant du tungstène contient des dépôts de carbure de tungstène nanocristallins.

6. Elément de glissement selon l'une quelconque des revendications précédentes,
**caractérisé en ce**
**que** la couche adhésive, en particulier une couche adhésive à base de chrome, présente une épaisseur de 1 µm au maximum.

7. Elément de glissement selon l'une quelconque des revendications précédentes,
**caractérisé en ce**
**que** la couche adhésive est vaporisée par métallisation.

8. Elément de glissement selon l'une quelconque des revendications précédentes,
**caractérisé en ce**
**que** la couche DLC contenant du métal et/ou la couche DLC sans métal sont réalisées au moyen d'un procédé PVD (par dépôt physique en phase vapeur) et/ou au moyen d'un procédé PECVD (par dépôt chimique en phase vapeur assisté par plasma).

9. Elément de glissement selon l'une quelconque des revendications précédentes,
**caractérisé en ce**
**que** l'épaisseur de la couche DLC sans métal présente, par rapport à l'épaisseur de la couche DLC contenant du métal, un rapport allant de 0,7 à 1,5 et/ou, par rapport à l'épaisseur totale du revêtement, un rapport allant de 0,4 à 0,6.

10. Elément de glissement selon l'une quelconque des revendications précédentes,
**caractérisé en ce**
**que** la couche DLC sans métal présente une proportion en azote supérieure à 5 % en atomes et/ou de 40 % en atomes au maximum, de préférence comprise entre 10 % en atomes et 25 % en atomes.

11. Elément de glissement selon l'une quelconque des revendications précédentes,
**caractérisé en ce**
**qu'**une zone extérieure de la couche DLC sans métal est dopée.

12. Elément de glissement selon l'une quelconque des revendications précédentes,
**caractérisé en ce**
**que** l'épaisseur de la zone dopée de la couche DLC sans métal représente 10 à 90 % de l'épaisseur de la zone non dopée de la couche DLC sans métal.
